# EUROPÄISCHE PATENTSCHRIFT

(11) **EP 0 434 797 B1**
(45) Veröffentlichungstag und Bekanntmachung des Hinweises auf die Patenterteilung: **02.11.1994**
(21) Anmeldenummer: 90909702.4
(22) Anmeldetag: 22.06.1990
(51) Int. Cl.: C23C 14/34, C23C 14/38, H01J 37/34

(54) **GERÄT ZUR BESCHICHTUNG VON SUBSTRATEN DURCH KATHODENZERSTÄUBUNG**
DEVICE FOR COATING SUBSTRATES BY CATHODE SPUTTERING
APPAREIL D'ENDUCTION DE SUBSTRATS PAR PULVERISATION CATHODIQUE

(30) Priorität: 24.06.1989 DE 3920772
(43) Veröffentlichungstag der Anmeldung: 03.07.1991
(73) Patentinhaber: Leyendecker, Toni, D-52068 Aachen (DE)
(72) Erfinder: LEYENDECKER, Toni, D-5100 Aachen (DE); LEMMER, Oliver, D-5100 Aachen (DE); ESSER, Stefan, D-5102 Wütselen (DE)
(74) Vertreter: Patentanwälte Wenzel & Kalkoff
(86) Internationale Anmeldenummer: EP9000999
(87) Internationale Veröffentlichungsnummer: WO9100378

(56) Entgegenhaltungen:
- EP-A- 0 003 020
- EP-A- 0 150 878
- DE-A- 2 148 933
- GLOW DISCHARGE PROCESSES, B. CHAPMAN, John Wiley and Sons 1980 Seiten 196-198.
- DÜNNSCHICHTTECHNOLOGIE, H.FREY UND G.KIENEL, VDJ-Verlag GmbH, Düsseldorf 1987, Seiten 108-113, 509-511.

## Beschreibung

Die Erfindung betrifft ein Gerät zur Beschichtung von Substraten durch Kathodenzerstäubung mit einer evakuierbaren Kammer, in der sich jeweils mindestens eine mit Beschichtungsmaterial versehene Kathode und eine Anode sowie das zu beschichtende Substrat befinden, mit einem Steuergerät zur Versorgung der Kathode mit einem negativen elektrischen Potential relativ zur Anode oder zur Kammerinnenwand und zur Versorgung der Anode mit einem positiven elektrischen Potential zur Kammerinnenwand sowie mit einem Gasanschluß und einem Gasauslaß zur Einleitung und Ableitung von Sondergasen bzw. zur Evakuierung, wobei die Anode die Ionisation innerhalb der Kammer fördert.

Derartige bekannte Geräte wie die Beschichtungsanlage von Typ Z550M der Fa. Leybold-Heraeus Gmbh 6450 Handu dargestellt und angeführt in dem Fachbuch von Frey U. Kienel "Dünnschichttechnologie", VDJ-Verlag GmbH, Düsseldorf 1987, S. 510/511, werden z.B. für die Beschichtung von Glasscheiben als UV-Filter kommerziell eingesetzt. Es werden dünnste Schichtdicken besonders gleichmäßig auf das Substrat aufgebracht, so daß der Umgang mit dem Beschichtungswerkstoff sparsam ist und auch ein Wechsel des Beschichtungsmaterials durch Austauschen der Kathode bzw. einer Kathodenblende sehr leicht möglich ist.

Der Beschichtungsvorgang läuft nach folgendem Schema ab: Innerhalb einer stark evakuierten Kammer wird z.B. eine bestimmte Konzentration von Argon aufrechterhalten. Innerhalb der Kammer befindet sich eine Kathode und eine Anode, wobei die Kathode das zu zerstäubende Material trägt und im übrigen im Bereich eines sog. Magnetronfeldes liegt, also eines Feldes aus elektrischen und magnetischen Kraftlinien. Die Ionen aus dem bei diesen Randbedingungen als Plasma vorliegenden Argon werden mit hoher Geschwindigkeit auf das an der Kathode befindliche Beschichtungsmaterial geschleudert, und beim Auftreffen auf die Oberfläche setzen sie wiederum teilweise als Ionen vorliegende Dampfpartikel des Beschichtungsmaterials frei, die aufgrund einer negativen Ladung des Substrates dorthin wandern und abgeschieden werden. Der Prozeß ist in der Regel begleitet von einer Glimmentladung.

Bei regelmäßigen Körpern wie Glasscheiben und dergleichen bedarf es zur Erzielung einer regelmäßigen Beschichtung lediglich einer flächenhaften Kathode, um die gewünschte hervorragende Güte der Beschichtung zu erzielen. Bei unregelmäßig gestalteten Substraten gibt es hingegen Schwierigkeiten. Die der Kathode abgewandten Bereiche werden stark porös beschichtet, mit der Folge, daß bei einer späteren Beschichtung mit günstigen Bedingungen beispielsweise nach einer Drehung des Substrates die Schichten hoher Qualität abplatzen. Es darf also zu einer porösen Abscheidung erst gar nicht kommen. Aufgrund dieser Schwierigkeiten werden die bekannten Geräte nur bei regelmäßigen und glattflächigen Substraten eingesetzt.

Aus "Glow discharge processes", B. Chapman, John Wiley & Sons, 1980, Seiten 196 - 198 ist ein Sputter-System bekannt, bei dem die das Beschichtungsmaterial aufweisende Kathode (auch "target" genannt) von einem auf Massepotential liegenden Ring umgeben ist. Der zu beschichtende Gegenstand, also das Substrat, ist von einer Elektrode gehalten, die ebenfalls von einen mit Masse verbundenen Ring umgeben ist. Über die Ausgestaltung der Anoden-Elektrode werden hierbei keinerlei Ausführungen gemacht. Normalerweise stellt die Kammer derartiger Sputter-Systeme die Anode dar, weshalb insofern eine separate in die Kammer hineinragende Elektrode nicht vorgesehen ist.

Es ist Aufgabe der Erfindung, ein Gerät der eingangs genannten Art so zu verbessern, daß auch unregelmäßige Substrate beschichtet werden können, und zwar mit einer allseits gut haftenden, hochwertigen Deckschicht.

Zur Lösung dieser Aufgabe schlägt die Erfindung vor, daß die Anode mit Hilfe der Blende teilweise abgedeckt ist und daß die Blende elektrisch leitend ausgebildet ist.

Es wurde überraschend gefunden, daß eine metallische Blende die Ionisation innerhalb der gesamten Kammer stark erhöht. An der elektrisch leitenden, insbesondere metallischen Blende bildet sich entweder aufgrund von Gleichgewichtsbedingungen ein eigenes Potential heraus, oder die Blende wird elektrisch mit der Kammerinnenwand verbunden, so daß ein kontrolliertes Potential vorhanden ist, nämlich das der Kammerinnenwand.

Die wirksame Anodenfläche, also die von der Blende nicht erfaßte Fläche der Anode bzw. diejenige Anodenfläche, die aufgrund einer Einschnürung des Zugangskanals infolge des Potentials als effektive Anodenfläche wirksam ist, wird nach der Kathodenleistung ausgewählt. Sie liegt zwischen 10 mm²/kw und 250 mm²/kw, wobei die exakte Wahl sich nach dem Druckniveau, der Kathodenleistung, der Gaszusammensetzung, dem Abstand des Substrates von der Kathode und nach der vorherrschenden Temperatur innerhalb der Kammer richtet. Die in dieser Weise definiert angehobene Ionisation innerhalb der Kammer hat den Effekt, daß außerhalb der Zone der Beschichtung die zu beschichtenden Flächen einem fortwährenden Ionenbombardement ausgesetzt werden, so daß unvollkommen abgelagerte Schichten und Strukturen entfernt werden, nämlich durch das sog. Ätzen, also durch den Beschuß z.B. mit Argonionen. Es bedarf lediglich eines Gleichgewichtes derart, daß der Abtrag durch die allgemein hohe Ionenkonzentration in den gerade beschichteten Zonen unterhalb des Beschichtungsauftrages liegt und andererseits eine fortwährende, gute Reinigung der noch zu beschichtenden Flächen erfolgt. Die Ausbildung der Anode gemäß der Erfindung sorgt für diese hohe Ionenkonzentration, die im übrigen durch das Anlegen eines Hauptpotentials zwischen Anode und Kathode und eines Nebenpotentials geringerer Spannung und Leistung zwischen Anode und der Kammerinnenwand unterstützt wird.

Das Nebenpotential kann durch eine eigene Spannungsquelle zwischen der Anode und der Kammerinnenwand gebildet werden, es ist jedoch ebenso möglich, das Nebenpotential dadurch zu bilden, daß die Kathode und die Anode jeweils über veränderbare Widerstände oder über den Mittelabgriff eines an den beiden Zuleitungen zu der Kathode und der Anode angeschlossenen, veränderbaren Widerstandes mit der Kammerinnenwand verbunden sind.

Bei Anoden, deren Blenden unmittelbar die der Kammerinnenseite zugewandten Stirnfläche abdecken, besteht die Gefahr, daß durch einen Schichtaufbau auf der wirksamen Anodenfläche der Abstand zwischen Anode und Blende abnimmt. Wenn dieser Abstand gering genug geworden ist, kann es zu direkten Entladungen zwischen der Anode und der Blende kommen, also zu Durchschlägen, die die Beschichtung stören, da das Potentialgefüge kurzfristig durcheinander gebracht wird. In Weiterbildung der Erfindung ist deshalb vorgesehen, daß die Blende rohrförmig ausgebildet ist und die ebenfalls vorzugsweise zylindrisch ausgebildete Anode konzentrisch umgibt.

Dabei ist überraschend gefunden worden, daß trotz unveränderter optisch gleichbleibender Abdeckung die unterschiedliche Relativlage der Rohrblende zu der Anode zu unterschiedlichen effektiven Anodenflächen führt. Es kommt also innerhalb der Rohrblende zu einer Einschnürung des Plasmas mit der Folge einer kleineren, wirksamen Anodenfläche, obwohl sich dem Innenraum der Kammer die gesamte Anodenfläche darbietet.

Während also der Abstand einer normalen Lochblende zu der Anode entweder nach und nach vergrößert werden muß bzw. die Blende und/oder die Anode gereinigt werden müssen, kommt es bei einer rohrförmigen Blende nicht bzw. nicht in dem Maße zu einer Annäherung durch aufwachsende Schichten. Deshalb ist eine Reinigung auch nach viel längeren Betriebsintervallen erforderlich.

In beiden Fällen ist jedoch eine gute Kühlung der Blende erforderlich, da sie fortwährend einem heftigen Ionenbeschuß ausgesetzt ist.

Normalerweise ist die wirksame Anodenfläche fest eingestellt. Bei komplizierten Substraten, die beschichtet werden müssen, kann es jedoch wegen sich verändernder Abstände der zu beschichtenden Flächen von der Kathode beispielsweise auf einem Drehteller oder dgl. notwendig sein, die effektive Anodenfläche während des Betriebes zu ändern. Die Erfindung sieht vor, daß dann die Anode oder die Blende mit Hilfe eines Faltenbalges gegenüber der Kammerwand abgedichtet sind, so daß von außen während des Betriebes eine Verstellung möglich ist.

Bei der Beschichtung von Substraten wie z.B. Bohrwerkzeugen und dgl. nach dem PVD-Verfahren mit Hartstoffsystemen, die z.B. zwei metallische Elemente (Aluminium und Titan) und zusätzlich Stickstoff enthalten bei geringeren Zudosierungen von z.B. Zirkon oder Vanadium zur Stabilisierung wird selbstverständlich auch die Kammerwand beschichtet. Diese Beschichtung ist insofern von Bedeutung, als sie eine Staubentwicklung bzw. Staubbildung in der Behandlungskammer verursachen kann. In dem Augenblick nämlich, in dem die Verlust-Beschichtung auf der Kammerinnenwand porös und inhomogen aufwächst, besteht die Gefahr,daß sich größere Partikel ablösen und als Verunreinigung auf dem Substrat abgeschieden werden. Aus diesem Grund müssen die Teile der Kammerinnenwand von Zeit zu Zeit insbesondere durch Strahlen gereinigt werden. Wenn hingegen die Beschichtung auf den Teilen der Kammerinnenwand in hoher Qualität entsteht, kann die Häufigkeit der Reinigung der Bestandteile der Kammerinnenwand im Vergleich zu einer Beschichtung mit einem porösen Aufwachsen um ein Drittel reduziert werden.

Es wurde überraschend gefunden, daß bei Hartstoffsystemen dann eine gute Verlust-Beschichtung zur Vermeidung einer Staubentwicklung entsteht, wenn das bereits eingangs genannte Nebenpotential zwischen der Anode und der Kammerinnenwand auf mindestens ca. 80 V eingestellt wird, wobei dann vorzugsweise ein Hauptpotential zwischen Anode und Kathode von ca. 500 V eingehalten wird. Messungen haben gezeigt, daß dann zwischen dem Plasma, also der Ionenwolke, die u.a. die Bestandteile des betreffenden Hartstoffsystems enthält, und der Kammerinnenwand ein Potential von mindestens 40 V vorherrscht. Im übrigen ist erfindungsgemäß vorgesehen, daß zur Vermeidung einer Staubentwicklung bzw. zur Vermeidung eines porösen Aufwachsens von Beschichtungen an der Kammerinnenwand diejenigen Potentiale eingestellt werden, die zu einem sehr guten Haftvermögen dieser Verlust-Beschichtung führen, um so die Staubbildung zu vermeiden.

Nachfolgend werden Ausführungsbeispiele der Erfindung, die in der Zeichnung dargestellt sind, näher erläutert; in der Zeichnung zeigen:
- Fig. 1: eine schematische Querschnittsansicht durch eine Anode gemäß der Erfindung in einem ersten Ausführungsbeispiel,
- Fig. 2: eine Querschnittsansicht gemäß der Figur 2 eines weiteren Ausführungsbeispieles,
- Fig. 3: ein schematisches Schaltbild der elektrischen Versorgung der Kammer eines Gerätes gemäß der Erfindung,
- Fig. 4: ein abgewandeltes Schaltbild der elektrischen Versorgung und
- Fig. 5: ein schematisches Schaltbild einer weiteren Variante der elektrischen Versorgung.

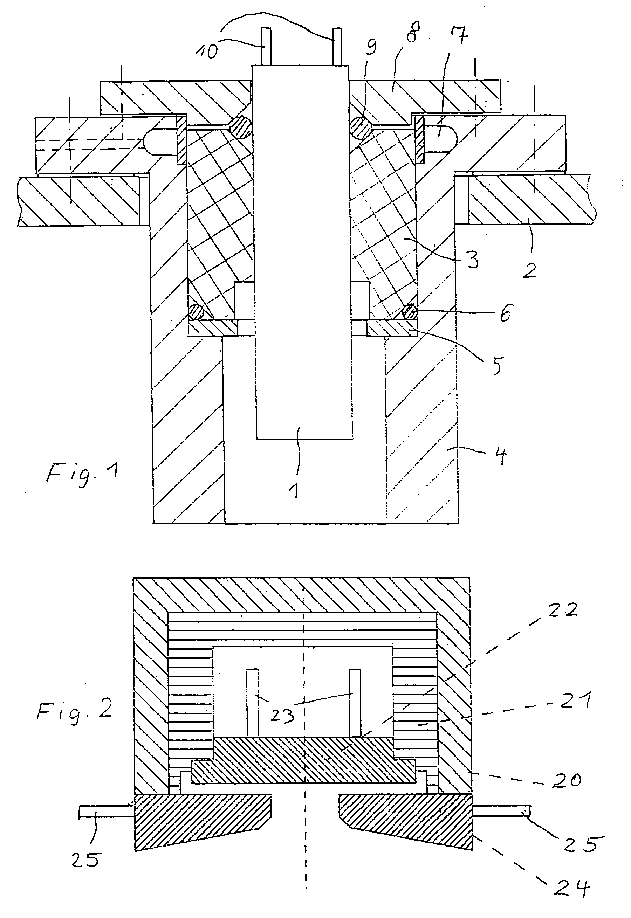

Die in der Figur 1 erkennbare Anode 1 ist in die Öffnung innerhalb einer Behälterwand 2 eingebaut, die das eigentliche Gerät zur Beschichtung von Substraten bildet. Ein entsprechendes Gerät ist z.B. in der Gebrauchsmusteranmeldung G 88 04 889.6 beschrieben. Die Anode 1 ist zylinderförmig mit einer geschlossenen Stirnwand geformt und ist von einem Isolierkörper 3 umgeben, der wiederum von einer Rohrblende 4 umschlossen ist. Die Rohrblende 4 ist dichtend von außen an der Behälterwand 2 angeschraubt, was durch strichpunktierte Linien angedeutet ist. Die Anode 1 wird mit Hilfe eines Dichtungsringes 9 nach außen hin abgedichtet, wobei der Dichtring 9 mit Hilfe eines Deckels 8 zur satten Anlage gebracht werden kann. Der Deckel 8 ist an dem Flansch der Rohrblende 4 angeschraubt, was wiederum durch strichpunktierte Linien angedeutet ist. Die Anode 1 ist also an der der Kammer abgewandten Seite von außen zugänglich. Dort befinden sich Rohranschlüsse 10 zum Einleiten und Ableiten von Kühlwasser. Eine weitere Kühlung ist an der Rohrblende 4 vorhanden, nämlich in Form eines Kühlkanales 7, der über entsprechende Zuleitungen und Ableitungen ständig beispielsweise von Kühlwasser durchflossen werden kann; in der Figur 1 ist der eine Kanal gestrichelt angedeutet.

Der Isolierkörper 3, der beispielsweise aus PTFE besteht, ist an der der Kammer zugewandten Seite mit Hilfe eines Schutzringes 5 geschützt, der beispielsweise aus korrosionsbeständigem Stahl besteht. An dieser Stelle ist ein weiterer Dichtring 6 vorhanden, der die Abdichtung zwischen der Rohrblende 4 und dem Isolierkörper 3 vornimmt.

Die Rohrblende 4 besteht vorzugsweise aus Kupfer, das eine hervorragende Wärmeleitfähigkeit aufweist. Deshalb genügt ein Kühlkanal 7 an der abgelegenen Stelle.

Es ist ohne weiteres erkennbar, daß die Kühlung der Rohrblende 4 auch weiter in die Kammer hinein ausgebildet werden kann, wenn sich das als erforderlich erweist. Als Material für die Rohrblende kommt korrosionsbeständiger Stahl in Frage, es können aber ebenso metallbeschichtete Keramikmaterialien eingesetzt werden, deren Kühlung dann nicht unbedingt erforderlich ist.

Es ist ohne weiteres erkennbar, daß die Anode 1 in Axialrichtung frei verschieblich ist, wenn die Anlagekraft der Dichtung 9 durch vorübergehendes Lösen des Deckels 8 gelockert wird. Mit Hilfe der Tiefeneinstellung der Anode 1 kann die effektive Anodenfläche beeinflußt werden. Je weiter die Anode 1 zurückgezogen ist, je geringer ist die effektive Anodenfläche, wobei ein Vorschieben über die dargestellte Position hinaus keine Vergrößerung mehr mit sich bringt. Die Verkleinerung der effektiven Fläche durch Zurückziehen ist eine Folge der Einschnürung des Plasmas im Bereich der Rohrblende 4 infolge der vorherrschenden Potentiale.

In der Fig. 2 ist ein weiteres Ausführungsbeispiel für eine Anode gemäß der Erfindung wiedergegeben, bei dem die effektive Fläche einer Anode 22 durch die Größe der Öffnung einer Lochblende 24 bestimmt wird. Mit Hilfe von Anschlußleitungen 23 bzw. 25 werden die Anode 22 sowie die Lochblende 24 wassergekühlt. Die in der Fig. 2 wiedergegebene Konstruktion ist für eine direkte Montage innerhalb der Kammer ohne Zugänglichkeit von außen bestimmt. Entsprechende Zuleitungen und Schläuche müssen also an geeigneter Stelle durch die Behälterwand hindurchgeführt werden.

Im übrigen ist die Anode 22 wiederum mit Hilfe eines Isolierkörpers 21 aus PTFE von der Lochblende 24 und von einem Gehäuse 20 getrennt, daß die Anode 22 insgesamt umgibt.

An den einander Zugewandten Seiten der Anode und der Lochblende 24 kommt es im fortlaufenden Beschichtungsbetrieb zu einem Schichtaufbau, der an dieser Stelle möglicherweise einen Durchschlag verursachen kann. Deshalb muß in vorgebenen Abständen eine Reinigung vorgenommen werden. Die Reinigungsintervalle können dann verlängert werden, wenn die Lochblende 24 abstandsvariabel zur Anode 22 ausgebildet ist und mit wachsender Gefahr eines Durchschlages der Abstand vergrößert werden kann.

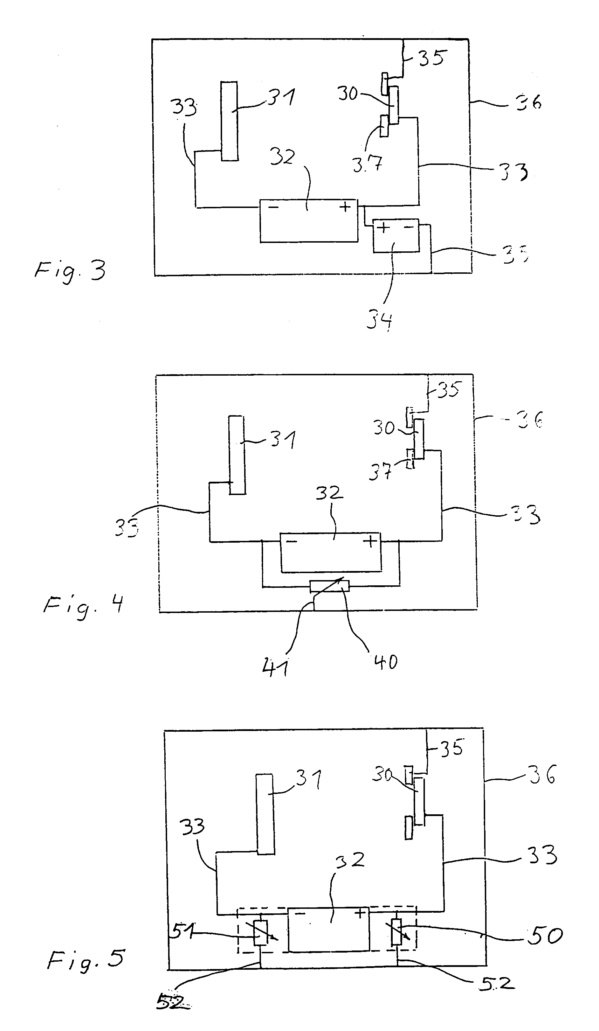

In den Fig. 3 bis 5 sind Beispiele für eine elektrische Stromversorgung des gesamten Gerätes gemäß der Erfindung wiedergegeben. Schematisch sind eine Anode 30 und eine Kathode 31 dargestellt, wobei die Anode 30 mit Hilfe einer Lochblende 37 teilweise abgedeckt ist. An ausgeführten Geräten befindet sich das Substrat (nicht dargestellt) annähernd unmittelbar vor der Kathode 31, wobei mit Hilfe eines Drehtellers oder mit Hilfe von Wendemechanismen auch eine wechselnde geometrische Zuordnung zu der Kathode 31 vorgenommen werden kann. Oftmals ist die Kathode 31 selbst auch innerhalb der Kammer ortsveränderlich gehalten.

Bei dem Ausführungsbeispiel gemäß der Fig. 3 wird mit Hilfe eines Hauptsteuergerätes 32 zwischen der Anode 30 und der Kathode 31 ein Hauptpotential aufrechterhalten, und mit Hilfe eines Nebensteuergerätes 34 wird zwischen der Anode 30 und der Kammerinnenwand 36 ein Nebenpotential geringerer Spannung und Leistung aufrechterhalten. Selbstverständlich befinden sich diese Steuergeräte 32 und 34 nicht innerhalb der Kammer, sondern sie sind Bestandteil der elektrischen Versorgung und Steuerung. Folglich verlaufen die Zuleitungen 33 und 35 durch die Kammerwandung hindurch zu diesen Geräten.

Die in den Figuren 4 und 5 wiedergebenen Ausführungsbeispiele für eine Schaltungsanordnung rufen dieselben Potentiale hervor, wie diejenigen, die in Verbindung mit der Fig. 3 beschrieben worden sind. Sie werden lediglich in unterschiedlicher Weise erzeugt.

Bei dem Ausführungsbeispiel gemäß der Fig. 4 ist zu der Spannungsquelle 32 ein variabler Widerstand 40 parallelgeschaltet, dessen Mittelabgriff an die Kammerinnenwand 36 angeschlossen ist. Von der Kammerinnenwand 36 ist auch eine Leitung 35 zu der Lochblende 37 gelegt. Damit liegt zwischen der Anode 30 und der Kammerinnenwand 36 ein Nebenpotential an, das für die Anhebung der Ionisation besonders günstig ist.

Bei dem Ausführungsbeispiel gemäß der Fig. 5 ist an jeder Leitung 33 ein variabler Widerstand 50 und 51 angeschlossen, dessen anderes Ende mit Hilfe einer Leitung 52 an der Kammerinnenwand 36 angeschlossen ist. Anhand der gestrichelten Linie wird verdeutlicht, daß die Einheit aus diesen variablen Widerständen 50 und 51 sowie der Spannungsquelle 32 an beliebiger Stelle eingebaut werden kann, selbstverständlich auch außerhalb der Kammer.

Zwar werden durch das negative Potential der Kammerinnenwand 36 Argonionen neutralisiert, also zu Molekülen zurückverwandelt, die von diesem negativen Potential weggeschleuderten Elektronen sind jedoch so zahlreich und so energiereich, daß durch das Auftreffen dieser Elektronen auf Argonmolekülen mehr Ionen entstehen als an der Innenwand 36 absorbiert bzw. neutralisiert werden. Dadurch kommt es zu der gewünschten stark ionisierenden Wirkung bei einem hohen positiven Potential an der Anode, einem hohen negativen Potential an der Kathode und einem ausreichend negativen Potential an der Kammerinnenwand 36.

Die Anodenausbildung gemäß der Erfindung in Verbindung mit einer abgestimmten Kathodenleistung führt zu einer so starken Ionisation innerhalb der gesamten Kammer, daß die der Kathode 31 zugewandten Bereiche des Substrates sicher beschichtet werden, die anderen, der Kathode 31 abgewandten Seite jedoch pausenlos infolge Ätzens gereinigt werden, so daß sie bei der zeitlich später liegenden Beschichtung beispielsweise durch Bewegen der Kathode 31 oder durch Bewegen des Substrates einen guten Haftgrund bilden.

## Patentansprüche

1. Gerät zur Beschichtung von Substraten durch Kathodenzerstäubung, mit
- einer evakuierbaren Kammer (2), in der sich jeweils mindestens eine mit Beschichtungsmaterial versehene Kathode (31) und eine Anode (1; 22; 30) sowie das zu beschichtende Substrat befinden,
- einem Steuergerät (32) zur Versorgung der Kathode (31) mit einem negativen elektrischen Potential relativ zur Anode (1; 22; 30) oder zur Kammerinnenwand (36) und zur Versorgung der Anode (1; 22; 30) mit einem positiven, elektrischen Potential relativ zur Kammerinnenwand (36) und
- einem Gaseinlaß und einem Gasauslaß zur Einleitung und Ableitung von Sondergasen und/oder zur Evakuierung der Kammer (2), wobei die Anode (1; 22; 30) die Ionisation innerhalb der Kammer (2) fördert,
dadurch **gekennzeichnet**,
- daß die Anode (1; 22; 30) zur Anpassung ihrer für den Ionisationsvorgang wirksamen Anodenfläche an die eingestellte Kathodenleistung durch eine Blende (4; 24; 37) teilweise abgedeckt ist und
- daß die Blende (4; 24; 37) elektrisch leitend ausgebildet ist.

2. Gerät nach Anspruch 1, dadurch **gekennzeichnet**, daß die Blende (4; 24; 37) dasselbe elektrische Potential aufweist wie die Kammerinnenwand (36).

3. Gerät nach Anspruch 1 oder 2, dadurch **gekennzeichnet**, daß die Blende (4, 24; 37) flüssigkeitsgekühlt ist.

4. Gerät nach einem der Ansprüche 1 bis 3, dadurch **gekennzeichnet**, daß die Anode (1) als stirnseitig verschlossener Zylinder ausgebildet ist

5. Gerät nach Anspruch 4, dadurch **gekennzeichnet**, daß die Blende (4) als Rohr ausgebildet ist, das die Anode (1) konzentrisch umgibt.

6. Gerät nach Anspruch 5, dadurch **gekennzeichnet**, daß die Relativlage der Rohrblende (4) und der Anode (1) zueinander in Axialrichtung einstellbar ist.

7. Gerät nach Anspruch 5 oder 6, dadurch **gekennzeichnet**, daß die Rohrblende (4) mit einem Flansch versehen ist, der eine Kammeröffnung umgibt und an der Kammer (2) befestigt ist.

8. Gerät nach Anspruch 7, dadurch **gekennzeichnet**, daß die Anode (1) innerhalb der Rohrblende (4) mit Hilfe eines Isolierkörpers (3) gehalten ist, wobei die Anode (1) gegen den Isolierkörper (3) und der Isolierkörper (3) gegen die Rohrblende (4) abgedichtet ist.

9. Gerät nach einem der Ansprüche 6 bis 8, dadurch **gekennzeichnet,** daß die Anode (1) während des Betriebs gegenüber dem Rohr (4) verschieblich ist.

10. Gerät nach Anspruch 9, dadurch **gekennzeichnet**, daß zwischen Anode (1) und Isolierkörper (3) ein metallischer Faltenbalg zur Abdichtung vorgesehen ist.

11. Gerät nach einem der Ansprüche 1 bis 4, dadurch **gekennzeichnet**, daß die Anode (1; 22; 30) und die Blende (4; 22) einander zugewandte Flächen aufweisen und daß der Abstand dieser Flächen einstellbar ist.

12. Gerät nach einem der vorhergehenen Ansprüche, dadurch **gekennzeichnet**, daß die Blende (4; 24; 37) aus Kupfer, korrosionsbeständigem Stahl oder aus einer metallisch beschichteten Keramik besteht.

13. Gerät nach einem der vorhergehenden Ansprüche, dadurch **gekennzeichnet**, daß zwischen der Anode (1; 24; 30) und der Kathode (31) ein Hauptpotentialunterschied und zwischen der Anode (1; 22; 30) und der Kammerinnenwand (36) ein Nebenpotentialunterschied geringerer Größe und Leistung anlegbar ist.

14. Gerät nach Anspruch 13, dadurch **gekennzeichnet**, daß der Nebenpotentialunterschied eine solche Stärke aufweist, daß eine an der Kammerinnenwand (36) abgeschiedene Beschichtung eine hohe Haftfestigkeit aufweist.

15. Gerät nach Anspruch 13, dadurch **gekennzeichnet**, daß der Nebenpotentialunterschied zwischen der Anode (1; 22; 30) und der Kammerinnenwand (36) mindestens ca. 80 V beträgt.

16. Gerät nach Anspruch 15, dadurch **gekennzeichnet**, daß der Hauptpotentialunterschied zwischen der Anode (1; 22; 30) und der Kathode (31) ca. 500 V beträgt.

17. Gerät nach einem der Ansprüche 13 bis 16, dadurch **gekennzeichnet**, daß die Kathode (31) und die Anode (1; 22; 30) zur Bildung des Nebenpotentialunterschieds jeweils über veränderbare Widerstände (51) mit der Kammerinnenwand (36) verbunden sind oder daß zwischen die Anode (1; 22; 30) und die Kathode (31) ein veränderbarer Widerstand (40) mit einem mit der Kammerinnenwand (36) verbundenen Mittelabgriff (41) geschaltet ist.

## Claims

1. Devices for coating substrates by cathode sputtering, with
- an evacuatable chamber (2) in which are located in each case at least one cathode (31) provided with coating material and one anode (1; 22; 30) as well as the substrate to be coated,
- a control device (32) for supply of the cathode (31) with a negative electric potential relative to the anode (1; 22; 30) or to the chamber inner wall (36) and for supply of the anode (1; 22; 30) with a positive electric potential relative to the chamber inner wall (36) and
- a gas inlet and a gas outlet for introducing and conducting away special gases and/or for evacuating the chamber (2), wherein the anode (1; 22; 30) promotes ionisation within the chamber (2),
characterised
- in that the anode (1; 22; 30) is partially covered by a screen (4; 24; 37) for adaptation of its anode surface which is effective for the ionisation process, to the set cathode power, and
- in that the screen (4; 24; 37) is electrically conducting.

2. Device according to claim 1, characterised in that the screen (4; 24; 37) has the same electrical potential as the chamber inner wall (36).

3. Device according to claim 1 or 2 characterised in that the screen (4; 24; 37) is liquid cooled.

4. Device according to any of claims 1 to 3, characterised in that the anode (1) is constructed as a cylinder closed at the end face.

5. Device according to claim 4, characterised in that the screen (4) is constructed as a tube which surrounds the anode (1) concentrically.

6. Device according to claim 5, characterised in that the relative position of the tubular screen (4) and the anode (1) in relation to each other is adjustable in the axial direction.

7. Device according to claim 5 or 6, characterised in that the tubular screen (4) is provided with a flange which surrounds a chamber opening and is attached to the chamber (2).

8. Device according to claim 7, characterised in that the anode (1) is held within the tubular screen (4) by means of an insulating body (3), wherein the anode (1) is sealed off from the insulating body (3) and the insulating body (3) is sealed off from the tubular screen (4).

9. Device according to any of claims 6 to 8, characterised in that the anode (1) is slidable relative to the tube (4) during operation.

10. Device according to claim 9, characterised in that between anode (1) and insulating body (3) is provided a metal bellows for sealing.

11. Device according to any of claims 1 to 4, characterised in that the anode (1; 22; 30) and the screen (4; 22) comprise surfaces facing towards each other and in that the distance between these surfaces is adjustable.

12. Device according to any of the preceding claims, characterised in that the screen (4; 24; 37) is made of copper, corrosion-resistant steel or a metal-coated ceramic.

13. Device according to any of the preceding claims, characterised in that between the anode (1; 24; 30) and the cathode (31) can be applied a main potential difference, and between the anode (1; 22; 30) and the chamber inner wall (36) can be applied an auxiliary potential difference of smaller quantity and capacity.

14. Device according to claim 13, characterised in that the auxiliary potential difference has a power such that a coating deposited on the chamber inner wall (36) displays a high bonding strength.

15. Device according to claim 13, characterised in that the auxiliary potential difference between the anode (1; 22; 30) and the chamber inner wall (36) is at least about 80 V.

16. Device according to claim 15, characterised in that the main potential difference between the anode (1; 22; 30) and the cathode (31) is about 500 V.

17. Device according to any of claims 13 to 16, characterised in that the cathode (31) and the anode (1; 22; 30) are connected to the chamber inner wall (36) in each case by variable resistors (51) to form the auxiliary potential difference or in that between the anode (1; 22; 30) and the cathode (31) is connected a variable resistor (40) with a centre tap (41) connected to the chamber inner wall (36).

## Revendications

1. Appareil pour le re vêtement de substrats par pulvérisation cathodique avec
- une chambre où l'on peut faire le vide (2) dans laquelle se trouvent respectivement au moins une cathode (31) pourvue de la matière de revêtement et une anode(1 ; 22 ; 30) ainsi que le substrat à revêtir,
- un appareil de commande (32) pour alimenter la cathode (31) avec un potentiel électrique négatif par rapport à l'anode (1 ;22 ;30) ou par rapport à la paroi intérieure de la chambre (36) et pour alimenter l'anode (1 ; 22 ; 30) avec un potentiel électrique positif par rapport à la paroi intérieure de la chambre (36) et
- une entrée de gaz et une sortie de gaz pour faire entrer et évacuer des gaz spéciaux et/ou pour faire le vide de la chambre (2), l'anode (1 ; 22 ; 30) favorisant l'ionisation à l'intérieur de la chambre (2),
**caractérisé en ce**
- que l'anode (1 ; 22 ; 30) est recouverte partiellement par un obturateur (4 ; 24 ; 37) pour adapter sa surface d'anode active pour le processus d'ionisation à la puissance de cathode réglée et
- que l'obturateur (4 ; 24 ; 37) est configuré en étant électroconducteur.

2. Appareil selon la revendication 1, **caractérisé en ce** que l'obturateur (4 ; 24 ; 37) présente le même potentiel électrique que la paroi intérieure de la chambre (36).

3. Appareil selon la revendication 1 ou 2, **caractérisé en ce** que l'obturateur (4, 24 ; 37) est refroidi par liquide.

4. Appareil selon l'une des revendications 1 à 3, **caractérisé en ce** que l'anode (1) est configurée comme un cylindre fermé sur la face de front.

5. Appareil selon la revendication 4, **caractérisé en ce** que l'obturateur (4) est configuré comme un tube qui entoure l'anode (1) concentriquement.

6. Appareil selon la revendication 5, **caractérisé en ce** que la position relative de l'obturateur en tube (4) et de l'anode (1) l'un par rapport à l'autre est réglable dans le sens axial.

7. Appareil selon la revendication 5 ou 6, **caractérisé en ce** que l'obturateur en tube (4) est équipé d'une bride qui entoure un orifice de la chambre et qui est fixée à la chambre (2).

8. Appareil selon la revendication 7, **caractérisé en ce** que l'anode (1) est maintenue à l'intérieur de l'obturateur en tube (4) à l'aide d'un corps isolant (3), l'anode (1) étant étanchée contre le corps isolant (3) et le corps isolant (3) contre l'obturateur en tube (4).

9. Appareil selon l'une des revendications 6 à 8, **caractérisé en ce** que l'anode (1) est translatable par rapport au tube (4) pendant le fonctionnement.

10. Appareil selon la revendication 9, **caractérisé en ce** qu'un soufflet métallique est prévu pour l'étanchement entre l'anode (1) et le corps isolant (3).

11. Appareil selon l'une des revendications 1 à 4, **caractérisé en ce** que l'anode (1 ; 22 ; 30) et l `obturateur (4 ; 22) présentent des surfaces tournées l'une vers l'autre et que la distance entre ces surfaces est réglable.

12. Appareil selon l'une des revendications précédentes, **caractérisé en ce** que l'obturateur (4 ; 24 ; 37) est en cuivre, en acier résistant à la corrosion ou en une céramique revêtue de métal.

13. Appareil selon l'une des revendications précédentes, **caractérisé en ce** qu'une différence de potentiel principal peut être appliquée entre l'anode (1 ; 24 ; 30) et la cathode (31) et une différence de potentiel secondaire de grandeur et de puissance inférieure peut être appliquée entre l'anode (1 ; 22 ; 30) et la paroi intérieure de la chambre (36).

14. Appareil selon la revendication 13, **caractérisé en ce** que la différence de potentiel secondaire présente une telle force qu'un revêtement déposé sur la paroi intérieure de la chambre (36) présente une grande force d'adhérence.

15. Appareil selon la revendication 13, **caractérisé en ce** que la différence de potentiel secondaire entre l'anode (1 ; 22 ; 30) et la paroi intérieure de la chambre (36) est d'au moins environ 80 V.

16. Appareil selon la revendication 15**, caractérisé en ce** que la différence de potentiel principal entre l'anode (1 ; 22 ; 30) et la cathode (31) est d'environ 500 V.

17. Appareil selon l'une des revendications 13 à 16, **caractérisé en ce** que la cathode (31) et l'anode (1 ; 22 ; 30) sont reliées à la paroi intérieure de la chambre (36) respectivement par des résistances variables (51) pour former la différence de potentiel secondaire ou qu'une résistance variable 40) avec une prise centrale (41) reliée à la paroi intérieure de la chambre (36) est mise en circuit entre l'anode (1 ; 22 ; 30) et la cathode (31).
